# EUROPEAN PATENT APPLICATION

(11) **EP 2 784 370 A2**
(43) Date of publication of application: **01.10.2014**
(21) Application number: 13183943.3
(22) Date of filing: 11.09.2013
(51) Int. Cl.: F21K 99/00, H01L 25/075, F21Y 101/02, F21Y 105/00, F21Y 113/00

(54) **Light-emitting module and luminaire**

(30) Priority: 25.03.2013 JP 2013062234
(71) Applicant: Toshiba Lighting & Technology Corporation, Yokosuka-shi, Kanagawa 237-8510 (JP)
(72) Inventor: Oyaizu, Tsuyoshi, Kanagawa, 237-8510 (JP)
(74) Representative: Bokinge, Ole

(57) **Abstract**

A light-emitting module (10) according to an embodiment includes a plurality of kinds of light-emitting elements (121,121) having different light emission colors. The light-emitting module (10) according to the embodiment includes a substrate (110) including an arrangement surface (110a) on which the light-emitting elements (121,121) are arranged, the different kinds of light-emitting elements (121,121) being alternately arranged in a plurality of directions on the arrangement surface (110a).

## Description

### FIELD

Embodiments described herein relate generally to a light-emitting module and a luminaire.

### BACKGROUND

In recent years, a luminaire including an LED (Light Emitting Diode) as a light source has been spreading. As the luminaire, a luminaire including a plurality of kinds of LEDs having different light emission colors is known. The luminaire irradiates light of a color obtained by mixing the light emission colors of the LEDs. However, when the luminaire of this type is used, lights of the different colors may not be mixed with each other. Therefore, it is likely that color irregularity occurs on a lighting surface.

### BRIEF DESCRIPTION OF THE DRAWINGS

FIG. 1 is a longitudinal sectional view illustrating a luminaire mounted with a light-emitting module according to an embodiment;
FIG. 2 is a top view illustrating the light-emitting module;
FIG. 3 is a diagram for explaining an arrangement example of LEDs according to the embodiment;
FIG. 4 is a diagram for explaining an arrangement example of the LEDs; and
FIG. 5 is a diagram for explaining arrangement positions of the LEDs.

### DETAILED DESCRIPTION

A light-emitting module 10 according to an embodiment described below includes a plurality of kinds of light-emitting elements having different light emission colors. For example, the light-emitting module 10 includes blue LEDs 121 and red LEDs 122 as the plurality of kinds of light-emitting elements. The light-emitting module 10 includes a substrate 110. The substrate 110 includes an arrangement surface 110a on which the light-emitting elements are arranged. The different kinds of light-emitting elements are alternately arranged in a plurality of directions on the arrangement surface 110a.

he light-emitting module 10 according to the embodiment described below includes a first wiring pattern (corresponding to a wiring pattern 151), a second wiring pattern (corresponding to a wiring pattern 152), and a third wiring pattern (corresponding to a wiring pattern 153). The first wiring pattern is provided on the substrate 110. The second wiring pattern is provided in a position a predetermined distance apart from the first wiring pattern. The third wiring pattern is provided in a position opposed to the first wiring pattern across the second wiring pattern. In other words, the third wiring pattern is provided in the position where the third wiring pattern sandwiches the second wiring pattern in between with the first wiring pattern. Among the plurality of kinds of light-emitting elements, an anode side of a first light-emitting element group connected in series is connected to the first wiring pattern. A cathode side of the first light-emitting element group is connected to the third wiring pattern. Among the plurality of kinds of light-emitting elements, a cathode side of a second light-emitting element group connected in series is connected to the second wiring pattern. An anode side of the second light-emitting element group is connected to the third wiring pattern.

In the light-emitting module 10 according to the embodiment described below, each of the plurality of kinds of light-emitting elements is arranged in any one of intersections of imaginary straight lines L101 to L112 drawn at equal intervals in a first direction (corresponding to a longitudinal direction H1) on the arrangement surface 110a and imaginary straight lines L201 to L212 drawn at equal intervals in a second direction (corresponding to a latitudinal direction H2) orthogonal to the first direction on the arrangement surface 110a.

On the substrate 110 according to the embodiment described below, the different kinds of light-emitting elements are alternately arranged in the first direction and the different kinds of light-emitting elements are alternately arranged in the second direction.

The light-emitting module 10 according to the embodiment described below includes a sealing section 140 made of resin configured to seal the plurality of kinds of light-emitting elements.

A luminaire 1 according to the embodiment described below includes the light-emitting module 10.

Hereinafter, a light-emitting module and a luminaire according to an embodiment are described with reference to the drawings. In the embodiment, the same components are denoted by the same reference numerals and signs and redundant explanation of the components is omitted. The number of LEDs illustrated in the figures is not limited to an example illustrated in the figures.

Longitudinal section example of a luminaire

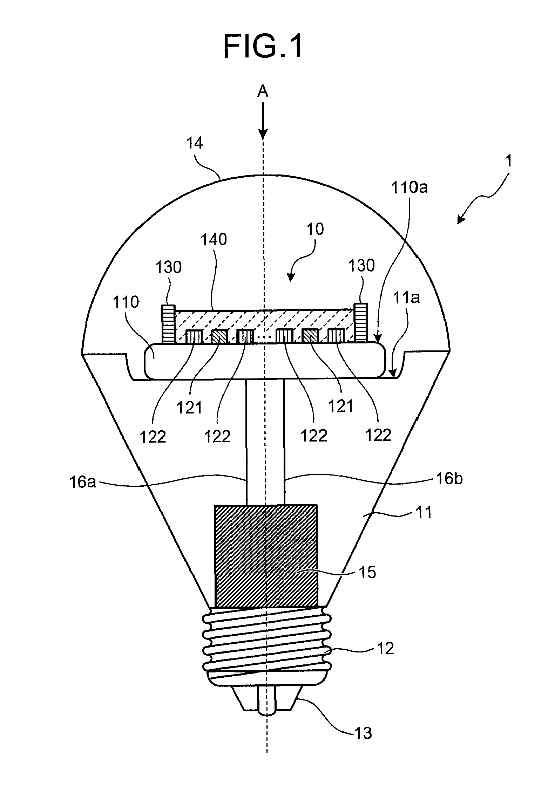

FIG. 1 is a longitudinal sectional view illustrating a luminaire mounted with a light-emitting module according to an embodiment. As illustrated in FIG. 1, a luminaire 1 according to the embodiment includes a light-emitting module 10, a main body 11, a cap member 12, an eyelet section 13, a cover 14, a control section 15, and electric wires 16a and 16b.

The light-emitting module 10 is arranged on an upper surface 11a of the main body 11. The light-emitting module 10 includes a substrate 110. The substrate 110 is formed of ceramics having low heat conductivity, for example, alumina, silicon nitride, silicon oxide, or aluminum.

Blue LEDs 121 and red LEDs 122 are arranged on an arrangement surface 110a of the substrate 110. The blue LEDs 121 are, for example, light-emitting elements that emit blue light, a peak of a wavelength of which is 450 [nm]. The red LEDs 122 are, for example, light-emitting elements that emit red light, a peak of a wavelength of which is 635 [nm].

On the arrangement surface 110a of the substrate 110, an annular blocking member 130 is arranged to surround the blue LEDs 121 and the red LEDs 122. A sealing section 140 is provided in a recess formed by the inner surface of the blocking member 130 and the arrangement surface 110a of the substrate 110. The sealing section 140 is formed by pouring any one of various kinds of resin in the recess and hardening the resin. For example, the sealing section 140 is formed of any one of various kinds of resin such as epoxy resin, urea resin, silicone resin, and highly diffusible transparent resin containing no phosphor. In this way, the blue LEDs 121 and the red LEDs 122 are entirely covered by the same sealing section 140 from above.

The main body 11 is formed of metal having high heat conductivity, for example, aluminum. The main body 11 is formed in a substantially circular columnar shape in a cross section. A cap member 12 is attached to one end of the main body 11. A cover 14 is attached to the other end of the main body 11. The main body 11 is formed such that an outer peripheral surface thereof is formed as a taper surface of a substantially conical shape, the diameter of which gradually increases in a direction from one end to the other hand. The main body 11 is formed in a shape, an external appearance of which is approximate to a silhouette of a neck section of a mini-krypton bulb. On the outer peripheral surface of the main body 11, a not-illustrated large number of thermal radiation fins, which radially project from one end to the other end, are integrally formed.

The cap member 12 is, for example, an E-type cap of an Edison type. The cap member 12 includes a cylindrical shell made of a copper plate including a thread ridge. The cap member 12 includes a conductive eyelet section 13 provided at an apex of a shell lower end via an electrically insulated section. An opening section of the shell is electrically insulated from an opening section of one end of the main body 11 and fixed. An input line led out from a power input terminal of a not-illustrated circuit board in the control section 15 is connected to the shell and the eyelet section 13. The cap member 12 is inserted into a socket provided on the ceiling or the like to supply electric power, which is supplied from a commercial power supply, to the control section 15.

The cover 14 is formed of, for example, milky-white polycarbonate. The cover 14 is formed in a smooth curved surface shape approximated to a silhouette of a mini-krypton bulb including an opening at one end. The cover 14 is fixed to the main body 11 with an opening end of the cover 14 fit in the main body 11 to cover a light-emitting surface of the light-emitting module 10. A method of fixing the cover 14 to the main body 11 may be any one of methods such as bonding, fitting, screwing, and locking.

The control section 15 includes a control circuit configured to control lighting of the blue LEDs 121 and the red LEDs 122 mounted on the substrate 110. The control circuit is housed in the control section 15 to be electrically insulated from the outside. The control section 15 converts an alternating-current voltage into a direct-current voltage according to the control by the control circuit and applies the converted direct-current voltage to the blue LEDs 121 and the red LEDs 122. In the control section 15, electric wires 16a and 16b for supplying electric power to the blue LEDs 121 and the red LEDs 122 are connected to an output terminal of the control circuit.

The electric wires 16a and 16b are led out to an opening section at the other end of the main body 11 via not-illustrated through-hole and a not-illustrated guide groove formed in the main body 11. Insulating films are peeled off from distal end portions of the electric wires 16a and 16b. The distal end portions of the electric wires 16a and 16b are connected to a below-mentioned connector 160 arranged on the substrate 110.

In this way, the control section 15 supplies electric power, which is input via the shell and the eyelet section 13, to the blue LEDs 121 and the red LEDs 122 via the electric wires 16a and 16b. The control section 15 collects, via the electric wires 16a and 16b, the electric power supplied to the blue LEDs 121 and the red LEDs 122.

Upper surface example of the light-emitting module

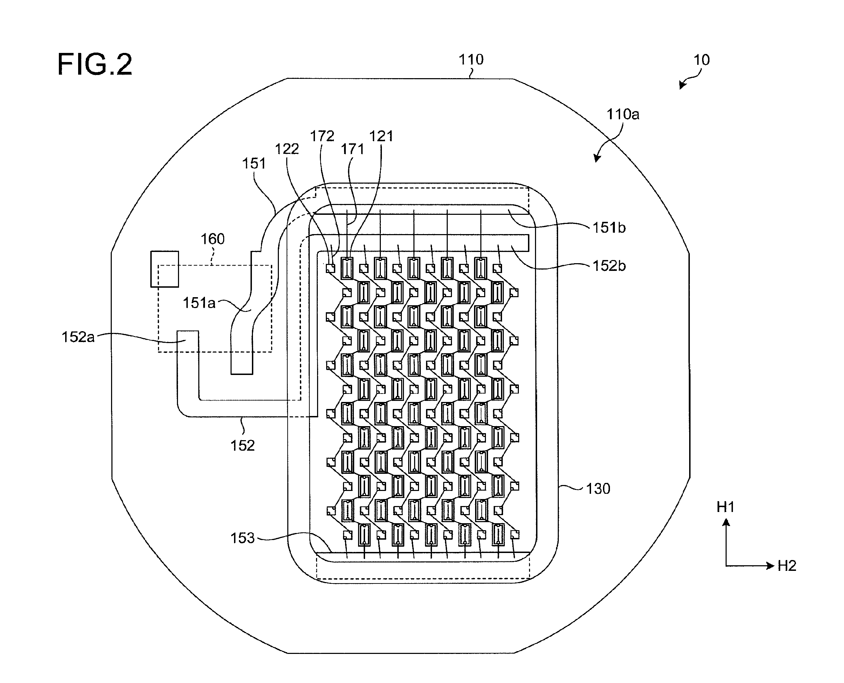

FIG. 2 is a top view illustrating the light-emitting module 10 according to the embodiment. FIG. 2 illustrates an example of the light-emitting module 10 viewed from an arrow A direction in FIG. 1. As illustrated in FIG. 2, the plurality of blue LEDs 121 and the plurality of red LEDs 122 are arranged on the arrangement surface 110a of the substrate 110. The blocking member 130 is arranged on the arrangement surface 110a of the substrate 110 to surround the blue LEDs 121 and the red LEDs 122.

In FIG. 2, one of the plurality of blue LEDs 121 is denoted by reference numeral "121". However, similar rectangular regions correspond to the blue LEDs 121. In FIG. 2, one of the plurality of red LEDs 122 is denoted by reference numeral "122". However, similar square regions correspond to the red LEDs 122.

Wiring patterns 151, 152, and 153 are formed on the wiring surface 110a of the substrate 110. The wiring patterns 151, 152, and 153 are electrical conductors printed on the substrate 110. A connector 160 is set on one end side 151a of the wiring pattern 151 and one end side 152a of the wiring pattern 152. As illustrated in FIG. 2, the other end side 151b of the wiring pattern 151 is formed in a linear shape. The other end side 152b of the wiring pattern 152 is formed in a linear shape in a position a predetermined distance apart from the other end side 151b of the wiring pattern 151. In the example illustrated in FIG. 2, the other end side 151b of the wiring pattern 151 and the other end side 152b of the wiring pattern 152 are formed substantially in parallel. The wiring pattern 153 is formed in a linear shape in a position opposed to the other end side 151b of the wiring pattern 151 across the other end side 152b of the wiring pattern 152.

The plurality of blue LEDs 121 are connected in series by bonding wires 171. In the example illustrated in FIG. 2, five series circuits that connect twelve blue LEDs 121 in series are arranged. In FIG. 2, one bonding wire is denoted by reference numeral "171". However, straight lines connecting the blue LEDs 121 and straight lines extending from the blue LEDs 121 correspond to the bonding wires 171.

An anode side in the series circuits of the blue LEDs 121 is connected to the other end side 151b of the wiring pattern 151. A cathode side in the series circuits of the blue LEDs 121 is connected to the wiring pattern 153.

The plurality of red LEDs 122 are connected in series by bonding wires 172. In the example illustrated in FIG. 2, six series circuits that connect twelve red LEDs 122 in series are arranged. In FIG. 2, one bonding wire is denoted by reference numeral "172". However, straight lines connecting the red LEDs 122 and straight lines extending from the red LEDs 122 correspond to the bonding wires 172.

An anode side in the series circuits of the red LEDs 122 is connected to the wiring pattern 153. A cathode side in the series circuits of the red LEDs 122 is connected to the other end side 152b of the wiring pattern 152.

The connector 160 is arranged to be electrically connected to the wiring patterns 151 and 152. The connector 160 is connected to the electric wires 16a and 16b illustrated in FIG. 1. Consequently, the connector 160 supplies electric power, which is supplied from the electric wires 16a and 16b, to the wiring pattern 151 and the wiring pattern 152.

That is, in the case of the example illustrated in FIG. 2, an electric current flows through the series circuits of the blue LEDs 121 and reaches the wiring pattern 153 from the other end side 151b of the wiring pattern 151 via the bonding wires 171. The electric current turns back in the wiring pattern 153, flows through the series circuits of the red LEDs 122, and reaches the other end side 152b of the wiring pattern 152 via the bonding wires 172.

In the light-emitting module 10 according to the embodiment, the blue LEDs 121 and the red LEDs 122 are alternately arranged in zigzag. Specifically, in the case of the example illustrated in FIG. 2, on the substrate 110, the blue LEDs 121 and the red LEDs 122 are alternately arranged in the longitudinal direction H1 of the blocking member 130. The blue LEDs 121 and the red LEDs 122 are alternately arranged in the latitudinal direction H2 of the blocking member 130. That is, the red LEDs 122 and the blue LEDs 121 are arranged such that light emission colors of both the LEDs adjacent to each other in the longitudinal direction H1 of the blocking member 130 are different and light emission colors of both the LEDs adjacent to each other in the latitudinal direction H2 of the blocking member 130 are different. The longitudinal direction H1 and the latitudinal direction H2 of the blocking member 130 are orthogonal to each other.

More specifically, in the case of the example illustrated in FIG. 2, the plurality of blue LEDs 121 connected in series are respectively arranged in apex sections (folding positions) of zigzag shapes. That is, the plurality of blue LEDs 121 connected in series are arranged in a lightening shape. Similarly, the plurality of red LEDs 122 connected in series are respectively arranged in apex sections (turn-back positions) of zigzag shapes. The plurality of blue LEDs 121 connected in series and the plurality of red LEDs 122 connected in series are alternately arranged. In this case, one of the blue LED 121 and the red LED 122 is arranged in a position surrounded by a trio of the other LEDs. For example, the blue LED 121 is arranged near the center of the base in a triangle formed by a continuous trio of the red LEDs 122. Similarly, the red LED 122 is arranged near the center of the base of a triangle formed by a continuous trio of the blue LEDs 121.

In this way, in the light-emitting module 10 according to the embodiment, since the blue LEDs 121 and the red LEDs 122 having the different light emission colors are alternately arranged, it is possible to mix blue light and red light well. Therefore, with the luminaire 1 according to the embodiment, it is possible to prevent color irregularity from occurring on a lighting surface on which irradiation light is irradiated.

In the light-emitting module 10 according to the embodiment, the blue LEDs 121 and the red LEDs 122 arranged on the substrate 110 are entirely covered by the same sealing section 140 from above. Consequently, with the light-emitting module 10 according to the embodiment, lights of different colors are mixed in the sealing section 140 made of resin or the like. Therefore, it is possible to more efficiently mix the irradiation light and further prevent color irregularity from occurring on the lighting surface.

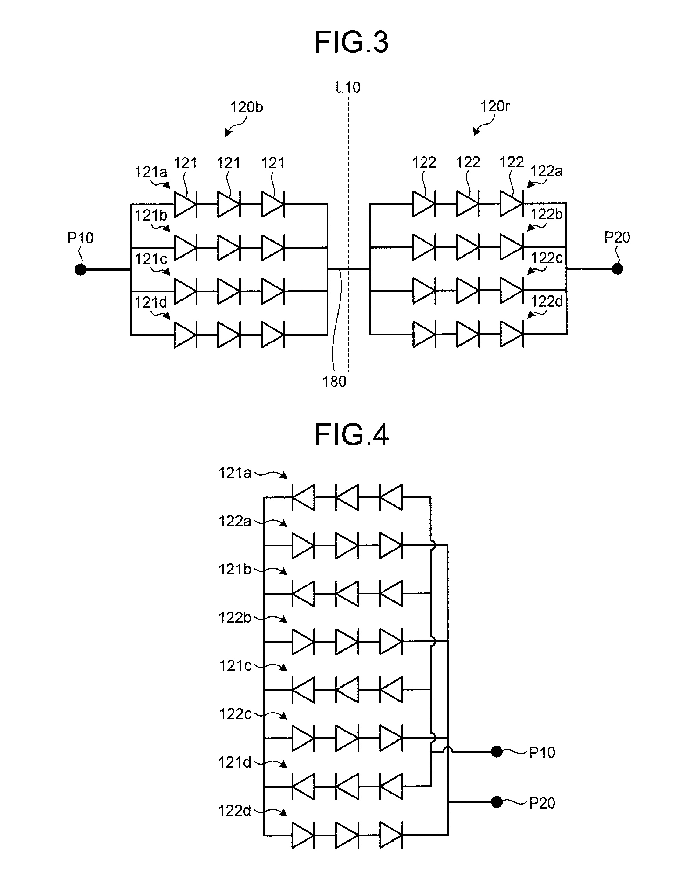

In the light-emitting module 10 according to the embodiment, the series circuits of the blue LEDs 121, which are first LEDs, are arranged and the series circuits of the red LEDs 122, which are second LEDs, are arranged to turn back from the ends of the former series circuits. Specifically, as explained above, the series circuits of the blue LEDs 121 are connected to the wiring pattern 151 and the wiring pattern 153. The series circuits of the red LEDs 122 are connected to the wiring pattern 152 and the wiring pattern 153 to turn back in the wiring pattern 153 on the end side of the series circuits of the blue LEDs 121. This point is explained with reference to circuit diagrams illustrated in FIGS. 3 and 4. FIGS. 3 and 4 are diagrams for explaining arrangement examples of the blue LEDs 121 and the red LEDs 122 according to the embodiment. The circuit diagrams illustrated in FIGS. 3 and 4 schematically illustrate arrangements of the blue LEDs 121 and the red LEDs 122.

In an example illustrated in FIG. 3, a blue LED group 120b and a red LED group 120r are connected in series by a wire 180. The blue LED group 120b includes blue LED groups 121a to 121d in each of which the three blue LEDs 121 are connected in series. The blue LED group 120b is formed by connecting the blue LED groups 121a to 121d in parallel. The red LED group 120r includes red LED groups 122a to 122d in each of which the three red LEDs 122 are connected in series. The red LED group 120r is formed by connecting the red LED groups 122a to 122d in parallel. In the case of this example, one end P10 of a circuit illustrated in the figure corresponds to an anode and the other end P20 of the circuit corresponds to a cathode.

The blue LEDs 121 and the red LEDs 122 according to the embodiment are represented by an equivalent circuit of a circuit folded along a folding line L10 illustrated in FIG. 3. That is, the blue LEDs 121 and the red LEDs 122 according to the embodiment is represented by a circuit diagram illustrated in FIG. 4. Actually, the light-emitting module 10 according to the embodiment does not include the wire 180 illustrated in FIG. 3. The wiring pattern 153 is set in the position of the wire 180.

In this way, with the light-emitting module 10 according to the embodiment, the wiring pattern 151, to which the anode side of the LEDs is connected, and the wiring pattern 152, to which the cathode side of the LEDs is connected, can be arranged in positions close to each other. Therefore, it is possible to simplify an overall wiring pattern. Specifically, in the light-emitting module 10 according to the embodiment, the wiring patterns 151, 152, and 153 only have to be provided. Other wiring patterns for connecting the LEDs are unnecessary. Therefore, with the light-emitting module 10 according to the embodiment, it is possible to realize a reduction in a circuit size.

Arrangement positions of the LEDs

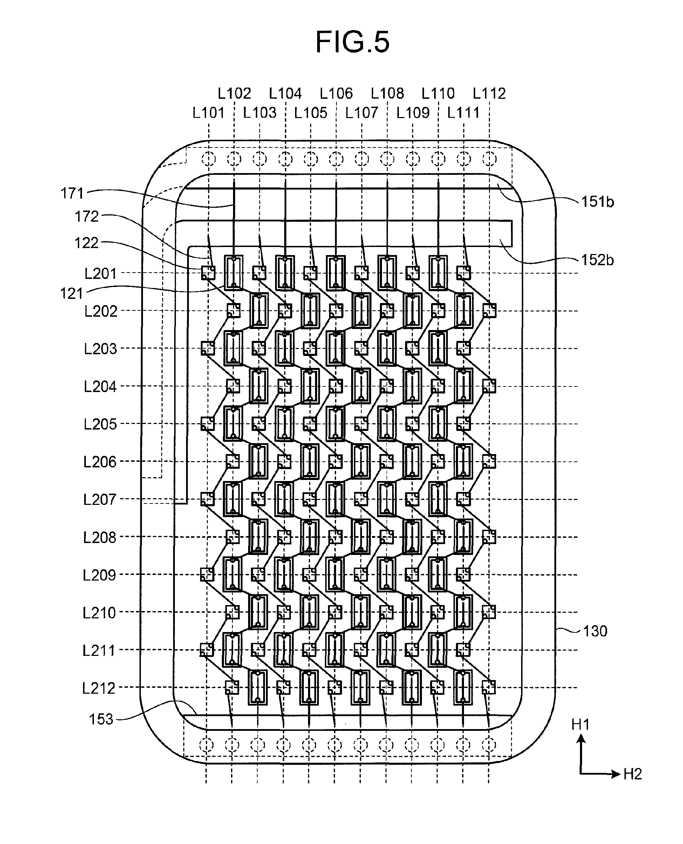

Arrangement positions of the blue LEDs 121 and the red LEDs 122 are explained with reference to FIG. 5. As illustrated in FIG. 5, each of the blue LEDs 121 and the red LEDs 122 according to the embodiment is arranged in any one of intersections of imaginary straight lines L101 to L112 in the longitudinal direction H1 drawn at substantially equal intervals and imaginary straight lines L201 to L212 in the latitudinal direction H2 drawn at substantially equal intervals. In this case, the blue LEDs 121 and the red LEDs 122 are arranged such that the intersections of the imaginary lines and the centers of the LEDs coincide with each other.

In other words, each of the blue LEDs 121 and the red LEDs 122 is arranged in any one of regions formed by dividing the arrangement surface 110a of the substrate 110 into the regions each having a predetermined size. In this case, the predetermined size for dividing the arrangement surface 110a is at least larger than the size of the blue LED 121 and the size of the red LED 122.

In this way, in the light-emitting module 10 according to the embodiment, each of the blue LEDs 121 and the red LEDs 122 is arranged in any one of the regions formed by equally dividing the arrangement surface 110a. Therefore, it is possible to reduce manufacturing man-hour. Specifically, when the light-emitting module 10 is manufactured, in a process called bonding or the like, the blue LEDs 121 and the red LEDs 122 are arranged on the arrangement surface 110a of the substrate 110 line by line. For example, the blue LEDs 121 and the red LEDs 122 are arranged in the longitudinal direction H1 while being translated in the latitudinal direction H2 of the blocking member 130. In this case, when the blue LEDs 121 and the red LED 122 are arranged as indicated by the example illustrated in FIG. 5, since the LEDs are arranged on a small number of rows, it is possible to reduce manufacturing man-hour of the light-emitting module 10.

### Other Embodiments

In the embodiment explained above, as indicated by the example illustrated in FIG. 2, the light-emitting module 10 includes the plurality of series circuits of the blue LEDs 121 connected in series in zigzag and the plurality of series circuits of the red LEDs 122 connected in series in zigzag. However, the light-emitting module 10 is not limited to this example. The light-emitting module 10 may include a plurality of series circuits in which the blue LEDs 121 and the red LEDs 122 are alternately linearly connected in series. In this case, the series circuits in which the blue LEDs 121 and the red LEDs 122 are alternately connected in series are arranged such that light emission colors of both the LEDs adjacent to each other in the longitudinal direction H1 are different and light emission colors of both the LEDs adjacent to each other in the latitudinal direction H2 are different.

In the example explained in the embodiment, the light-emitting module 10 includes the blue LEDs 121 and the red LEDs 122. However, the light-emitting module 10 is not limited to this example. The light-emitting module 10 may include LEDs that emit lights of colors other than blue and red. For example, the light-emitting module 10 may include LEDs that emit lights of white and green.

In the example explained in the embodiment, the light-emitting module 10 includes the two kinds of LEDs (the blue LEDs 121 and the red LEDs 122). However, the light-emitting module 10 is not limited to this example. The light-emitting module 10 may include three or more kinds of LEDs. In this case, the three or more kinds of LEDs are respectively alternately arranged. For example, it is assumed that the light-emitting module 10 includes blue LEDs, red LEDs, and white LEDs. In this case, the blue LEDs, the red LEDs, and the white LEDs are arranged in order in the longitudinal direction H1 of the blocking member 130 and the blue LEDs, the red LEDs, and the white LEDs are arranged in order in the latitudinal direction H2 of the blocking member 130.

In the example explained in the embodiment, the luminaire 1 is the bulb. However, the luminaire 1 including the light-emitting module 10 is not limited to the bulb. For example, the luminaire 1 can also be applied to a downlight type luminaire, a floodlight, and the like.

The shapes, the materials, and the quality of the materials of the members according to the embodiment are not limited to those explained in the embodiment and illustrated in the figures. For example, the blue LEDs 121 and the red LEDs 122 may be arranged in a circular region rather than the rectangular region. The cover 14 may be rectangular or elliptical rather than circular.

As described above, according to the above embodiment, it is possible to prevent color irregularity from occurring on the lighting surface.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A light-emitting module (10) comprising:
a plurality of kinds of light-emitting elements (121,121) having different light emission colors; and
a substrate (110) including an arrangement surface (110a) on which the light-emitting elements (121,121) are arranged, the different kinds of light-emitting elements (121,121) being alternately arranged in a plurality of directions on the arrangement surface (110a).

2. The light-emitting module (10) according to claim 1, further comprising:
a first wiring pattern (151) provided on the substrate (110);
a second wiring pattern (152) provided in a position a predetermined distance apart from the first wiring pattern (151); and
a third wiring pattern (153) provided in a position opposed to the first wiring pattern (151) across the second wiring pattern (152), wherein
among the plurality of kinds of light-emitting elements (121,121), an anode side of a first light-emitting element group connected in series is connected to the first wiring pattern (151) and a cathode side of the first light-emitting element group is connected to the third wiring pattern (153), and
among the plurality of kinds of light-emitting elements (121,121), a cathode side of a second light-emitting element group connected in series is connected to the second wiring pattern (152) and an anode side of the second light-emitting element group is connected to the third wiring pattern (153).

3. The light-emitting module (10) according to claim 2 or 3, wherein each of the plurality of kinds of light-emitting elements (121,121) is arranged in any one of intersections of imaginary straight lines (L101 to L112) drawn at equal intervals in a first direction (H1) on the arrangement surface (110a) and imaginary straight lines (L201 to L212) drawn at equal intervals in a second direction (H2) orthogonal to the first direction (H1) on the arrangement surface (110a).

4. The light-emitting module (10) according to claim 3, wherein, on the substrate (110), the different kinds of light-emitting elements (121,121) are alternately arranged in the first direction (H1) and the different kinds of light-emitting elements (121,121) are alternately arranged in the second direction (H2).

5. The light-emitting module (10) according to any one of claims 1 to 4, further comprising a sealing section (140) made of resin configured to seal the plurality of kinds of light-emitting elements (121,121).

6. A luminaire comprising:
the light-emitting module (10) according to any one of claims 1 to 5.
